# EUROPÄISCHE PATENTSCHRIFT

(11) **EP 3 774 440 B1**
(45) Veröffentlichungstag und Bekanntmachung des Hinweises auf die Patenterteilung: **19.02.2025**
(21) Anmeldenummer: 19718304.9
(22) Anmeldetag: 12.04.2019
(51) Int. Cl.: B60L 58/16, G01R 31/3842, G01R 31/392, G01R 31/396, G01R 31/389, G01R 31/367, H01M 10/48, H01M 10/42

(54) **VERFAHREN ZUR ERMITTLUNG EINES ALTERUNGSZUSTANDES EINER BATTERIE, COMPUTERPROGRAMM, SPEICHERMITTEL, STEUERGERÄT UND FAHRZEUG**
METHOD FOR DETERMINING AN AGEING CONDITION OF A BATTERY, COMPUTER PROGRAM, MEMORY MEANS, CONTROL DEVICE AND VEHICLE
PROCÉDÉ PERMETTANT DE DÉTERMINER UN ÉTAT DE VIEILLISSEMENT D'UNE BATTERIE, PROGRAMME INFORMATIQUE, SUPPORT DE STOCKAGE, APPAREIL DE COMMANDE ET VÉHICULE

(30) Priorität: 12.04.2018 DE 102018108738
(43) Veröffentlichungstag der Anmeldung: 17.02.2021
(73) Patentinhaber: VOLKSWAGEN AKTIENGESELLSCHAFT, 38440 Wolfsburg (DE)
(72) Erfinder: NOERING, Fabian, 38304 Wolfenbüttel (DE); WÜNSCH, Martin, 38110 Braunschweig (DE); JONAS, Konstantin, 10829 Berlin (DE); FÜSSLER, Rainer, 38112 Braunschweig (DE)
(74) Vertreter: Bals & Vogel Patentanwälte PartGmbB
(86) Internationale Anmeldenummer: PCT/EP2019/059372
(87) Internationale Veröffentlichungsnummer: WO 2019/197592

(56) Entgegenhaltungen:
- EP-A1- 1 892 536
- US-A- 4 678 998
- US-A1- 2011 208 452
- US-A1- 2011 208 452
- US-A1- 2015 226 812
- US-A1- 2017 219 660
- US-A1- 2017 219 660
- WAHYUDDIN M IWAN ET AL: "Direct current load effects on series battery internal resistance", 2017 15TH INTERNATIONAL CONFERENCE ON QUALITY IN RESEARCH (QIR) : INTERNATIONAL SYMPOSIUM ON ELECTRICAL AND COMPUTER ENGINEERING, IEEE, 24 July 2017 (2017-07-24), pages 120 - 123, XP033263720, DOI: 10.1109/QIR.2017.8168465
- WANG XUEYUAN ET AL: "State Estimation of Lithium Ion Battery Based on Electrochemical Impedance Spectroscopy with On-Board Impedance Measurement System", 2015 IEEE VEHICLE POWER AND PROPULSION CONFERENCE (VPPC), IEEE, 19 October 2015 (2015-10-19), pages 1 - 5, XP032833970, DOI: 10.1109/VPPC.2015.7353021
- WAHYUDDIN M IWAN ET AL: "Direct current load effects on series battery internal resistance", 2017 15TH INTERNATIONAL CONFERENCE ON QUALITY IN RESEARCH (QIR) : INTERNATIONAL SYMPOSIUM ON ELECTRICAL AND COMPUTER ENGINEERING, IEEE, 24 July 2017 (2017-07-24), pages 120 - 123, XP033263720, DOI: 10.1109/QIR.2017.8168465
- WANG XUEYUAN ET AL: "State Estimation of Lithium Ion Battery Based on Electrochemical Impedance Spectroscopy with On-Board Impedance Measurement System", 2015 IEEE VEHICLE POWER AND PROPULSION CONFERENCE (VPPC), IEEE, 19 October 2015 (2015-10-19), pages 1 - 5, XP032833970, DOI: 10.1109/VPPC.2015.7353021

## Beschreibung

Die vorliegende Erfindung betrifft ein Verfahren zur Ermittlung eines Alterungszustandes einer Batterie, die zur Energieversorgung eines Elektromotors eines Fahrzeugs zum Antreiben eines Fahrzeugs bereitgestellt ist. Die Erfindung betrifft ferner ein Computerprogramm zur Ermittlung eines Alterungszustandes einer Batterie, ein Speichermittel mit einem darauf gespeicherten Computerprogramm zur Ermittlung eines Alterungszustandes einer Batterie, ein Steuergerät mit einem darauf installierten Computerprogramm zur Ermittlung eines Alterungszustandes einer Batterie sowie ein Fahrzeug mit einem solchen Steuergerät.

Bei einem Elektrofahrzeug ist die Kenntnis des Alterungszustandes (State-of-Health, SOH) der Fahrzeugbatterie beziehungsweise Traktionsbatterie, die zur Energieversorgung des Elektromotors zum Antreiben des Elektrofahrzeugs bereitgestellt ist, wichtig. Den Alterungszustand zu bestimmen ist jedoch aufgrund von komplexen Vorgängen beim Laden und Entladen der Fahrzeugbatterie eine anspruchsvolle Aufgabe. In aktuellen Serienfahrzeugen sind meist nur Schätzsysteme zum Schätzen des Alterungszustandes der Fahrzeugbatterie implementiert, deren Genauigkeit für viele Anwendungen nicht ausreicht.

Eine Möglichkeit den Alterungszustand zu schätzen oder zu ermitteln ist die Impedanzspektroskopie. Hierbei werden auf den Strom von Batteriezellen der Fahrzeugbatterie verschiedene sinusförmige Frequenzen aufgeprägt. Anhand deren Spannungsantwort kann anschließend auf die Impedanz der Fahrzeugbatterie beziehungsweise der einzelnen Batteriezellen geschlossen werden. Die Impedanz ist eine Größe, durch welche sich die Alterung der Batteriezelle ausdrücken lässt. Für die Durchführung einer solchen Impedanzspektroskopie wird bisher ein aufwendiger Messaufbau mit separater, hochwertiger Sensorik verwendet. Dies verursacht hohe Kosten und ist bei mobilen Systemen wie einem Elektrofahrzeug nur bedingt anwendbar.

Aktuell werden deshalb Lösungen gesucht, um die Impedanzspektroskopie mit vertretbarem Aufwand auch in Elektrofahrzeugen im mobilen Einsatz derselben durchführen zu können. Die Lösungen basieren dabei meist auf der Entwicklung von Verfahren zur zusätzlichen Anregung der Batterie im Fahr- oder Ladebetrieb.

In der US-amerikanischen Patentanmeldung US 2011/0208452 A1 wird ein nicht-invasives Verfahren zum Ermitteln der elektrischen Impedanz einer Fahrzeugbatterie eines Elektrofahrzeugs vorgeschlagen. Insbesondere wird vorgeschlagen, die im Elektrofahrzeug bereits verfügbare Sensorik zur Ermittlung der Impedanz der Fahrzeugbatterie beziehungsweise der Batteriezellen der Fahrzeugbatterie zu nutzen. Hierfür werden Betriebsparameter der Fahrzeugbatterie, wie eine Batteriespannung und ein Batteriestrom, gemessen und in definierte Frequenzbereiche transformiert. Anschließend werden in diesen Frequenzbereichen die Impedanzen der Batteriezellen berechnet und basierend auf den berechneten Impedanzen der Alterungszustand der Fahrzeugbatterie ermittelt. Diese Vorgehensweise erfüllt jedoch noch nicht die gewünschte Genauigkeit bei der Ermittlung des Alterungszustandes der Fahrzeugbatterie. Weitere Systeme und Verfahren zur Ermittlung eines Alterungszustandes einer Batterie werden in der US 4 678 998 A sowie der EP 1 892 536 A1 beschrieben.

Aufgabe der vorliegenden Erfindung ist es, der voranstehenden Problematik zumindest teilweise Rechnung zu tragen. Insbesondere ist es Aufgabe der vorliegenden Erfindung, ein Verfahren, ein Computerprogramm, ein Speichermittel, ein Steuergerät sowie ein Fahrzeug mit einem Steuergerät zur kostengünstigen, mobilen und/oder möglichst genauen Ermittlung des Alterungszustands einer Batterie, insbesondere einer Fahrzeugbatterie, zu schaffen.

Die voranstehende Aufgabe wird durch die Patentansprüche gelöst. Insbesondere wird die voranstehende Aufgabe durch das Verfahren gemäß Anspruch 1, das Computerprogramm gemäß Anspruch 6, das Speichermittel gemäß Anspruch 7, das Steuergerät gemäß Anspruch 8 sowie das Fahrzeug gemäß Anspruch 9 gelöst. Weitere Vorteile der Erfindung ergeben sich aus den Unteransprüchen, der Beschreibung und den Figuren. Dabei gelten Merkmale, die im Zusammenhang mit dem Verfahren beschrieben sind, selbstverständlich auch im Zusammenhang mit dem erfindungsgemäßen Computerprogramm, dem erfindungsgemäßen Speichermittel, dem erfindungsgemäßen Steuergerät, dem erfindungsgemäßen Fahrzeug und jeweils umgekehrt, sodass bezüglich der Offenbarung zu den einzelnen Erfindungsaspekten stets wechselseitig Bezug genommen wird beziehungsweise werden kann.

Gemäß einem ersten Aspekt der vorliegenden Erfindung wird ein Verfahren zur Ermittlung eines Alterungszustandes einer Batterie, insbesondere einer Fahrzeugbatterie, die zur Energieversorgung eines Elektromotors, insbesondere eines Elektromotors zum Antreiben eines Fahrzeugs, bereitgestellt ist, zur Verfügung gestellt. Das Verfahren weist die folgenden Schritte auf:
- Ermitteln eines Verlaufs einer Betriebsspannung der Batterie (und eines Betriebsstroms der Batterie in Echtzeit während eines Fahrbetriebs des Fahrzeugs,
- Überprüfen des ermittelten Verlaufs der Betriebsspannung der Batterie (10) und des ermittelten Verlaufs des Betriebsstroms der Batterie auf sinusförmige Kurvenabschnitte unterschiedlicher Frequenzen,
- wenn sinusförmige Kurvenabschnitte erkannt werden, Extrahieren der erkannten sinusförmigen Kurvenabschnitte unterschiedlicher Frequenzen,
- Berechnen einer Impedanz der Batterie mittels Impedanzspektroskopie anhand der sinusförmigen Kurvenabschnitte, und
- Ermitteln des Alterungszustandes der Batterie anhand der berechneten Impedanz.

Im Rahmen der vorliegenden Erfindung wurde erkannt, dass durch eine gezielte Filterung der sinusförmigen Kurvenabschnitte für die anschließende Impedanzspektroskopie die Ergebnisse hinsichtlich der Ermittlung des Alterungszustandes der Batterie, insbesondere einer Fahrzeugbatterie, auf einfache Weise erheblich verbessert werden kann. Auf die bisher erforderliche zusätzliche Aufprägung von Sinusschwingungen durch externe Systembauteile kann dadurch verzichtet werden. Das heißt, das vorgeschlagene Verfahren kann ausschließlich mit der bereits vorhandenen Sensorik und Leistungselektronik des Fahrzeugs durchgeführt werden. Mithin kann das Verfahren besonders kostengünstig, mobil und entsprechend flexibel durchgeführt werden.

Bei der Durchführung des erfindungsgemäßen Verfahrens werden die sinusförmigen Kurvenabschnitte gespeichert, sobald diese identifiziert beziehungsweise erkannt wurden. Sobald ein für die Impedanzspektroskopie notwendiges Frequenzspektrum vollständig erfasst ist, kann eine Impedanz berechnet werden. Die berechnete Impedanz kann anschließend mittels physikalischer Alterungsmodelle und/oder mathematischer Modelle in den Gesundheitszustand umgerechnet werden.

Die beispielsweise während eines Fahrbetriebs des Fahrzeugs gemessenen Ströme können in Echtzeit auf vorhandene sinusförmige Kurvenabschnitte, insbesondere auf vorhandene sinusförmige Kurvenabschnitte unterschiedlicher Frequenzen, analysiert werden. Im Rahmen dieser Vorgehensweise kann das Verfahren besonders einfach im mobilen Einsatz, beispielsweise während einer Fahrt des Fahrzeugs, durchgeführt werden. Unter Echtzeit kann der Betrieb eines Rechensystems verstanden werden, bei dem Programme zur Verarbeitung anfallender Daten ständig betriebsbereit sind, und zwar derart, dass die Verarbeitungsergebnisse innerhalb einer vorgegebenen Zeitspanne verfügbar sind. Die Daten, vorliegend Daten zum graphischen Verlauf bzw. zum Kurvenverlauf der Betriebsspannung und/oder des Betriebsstroms, können je nach Anwendungsfall nach einer zeitlich zufälligen Verteilung oder zu vorherbestimmten Zeitpunkten anfallen. Das heißt, der graphische Verlauf wird vorliegend zumindest zeitweise kontinuierlich und ohne wesentliche Verzögerungen durchgeführt.

Die sinusförmigen Kurvenabschnitte können mittels einer Zeitreihenanalyse erkannt werden. So können beispielsweise über die Bestimmung einer Ähnlichkeit zwischen einem aktuell gemessenen Stromverlauf und einer Referenz-Sinusschwingung relevante sinusförmige Kurvenabschnitte identifiziert werden. Das heißt, es können Ähnlichkeitsalgorithmen zur Erkennung von relevanten Frequenzen beziehungsweise Frequenzbereichen in der Batteriespannung und im Batteriestrom, genutzt werden. Ein entsprechender graphischer Verlauf der Betriebsspannung und des Betriebsstroms wird vorzugsweise auf die sinusförmigen Abschnitte in unterschiedlichen Frequenzen überprüft beziehungsweise analysiert. Das heißt, es wird untersucht, ob in unterschiedlichen Frequenzabschnitten der Betriebsspannung und/oder des Betriebsstroms wenigstens ein sinusförmiger Abschnitt erfasst werden kann.

Unter der Batterie beziehungsweise Fahrzeugbatterie kann vorliegend ein Akkumulator, wie eine Lithium-Ionen-Batterie, oder eine Brennstoffzelle verstanden werden. Demnach lässt sich das Verfahren sowohl in Batterie-Elektrofahrzeugen als auch in Brennstoffzellenfahrzeugen durchführen. Das Fahrzeug kann als reines Elektrofahrzeug oder als Hybrid-Elektrofahrzeug ausgestaltet sein.

Unter dem Alterungszustand kann ein Gesundheitszustand beziehungsweise der State-of-Health der Batterie, also eine Kenngröße zum Funktionszustand der Batterie, verstanden werden.

Die Fahrzeugbatterie für die Energieversorgung des Elektromotors zum Antreiben des Fahrzeugs ist die Batterie, mit Hilfe welcher das Fahrzeug angetrieben werden kann. Das heißt, die Fahrzeugbatterie ist die elektrochemische Energiequelle des Fahrzeugs, mit welcher der Elektromotor zur Fortbewegung des Fahrzeugs mit Strom und Spannung versorgt wird. Die Fahrzeugbatterie ist deshalb insbesondere als entsprechende Hochvoltbatterie zu verstehen. Gleichwohl soll das erfindungsgemäße Verfahren nicht auf die Anwendung bei einer solchen Batterie beschränkt betrachtet werden. Grundsätzlich ist es auch möglich, das Verfahren bei jedem anderen Batteriespeicher beziehungsweise Akkumulator anzuwenden.

Unter dem sinusförmigen Kurvenabschnitt ist bevorzugt ein Kurvenabschnitt der Betriebsspannung und/oder ein Kurvenabschnitt des Betriebsstroms über die Zeit zu verstehen, welcher nach einem abfallenden Verlauf einen ansteigenden Verlauf und anschließend wieder einen abfallenden Verlauf aufweist. Der sinusförmige Kurvenabschnitt muss nicht einem perfekten Sinuskurvenverlauf entsprechen.

Darunter, dass die sinusförmigen Kurvenabschnitte aus der ermittelten Betriebsspannung und/oder aus dem ermittelten Betriebsstrom bzw. aus deren Verläufen extrahiert werden, kann verstanden werden, dass die sinusförmigen Kurvenabschnitte für die anschließende Berechnung der Impedanz der Batterie beziehungsweise der Batteriezellen der Batterie verwendet werden. Im Rahmen der Extrahierung können die sinusförmigen Kurvenabschnitte gespeichert werden. Sobald dann ein für die Impedanzspektroskopie notwendiges Frequenzspektrum vollständig gespeichert und entsprechend erfasst ist, kann, wie vorstehend beschrieben, die Impedanz der Batterie berechnet werden.

Ein Ermitteln des Alterungszustandes der Batterie anhand der berechneten Impedanz kann dahin gehend durchgeführt werden, dass der Alterungszustand der Batterie unter Verwendung der berechneten Impedanz, beispielsweise unter Anwendung der physikalischen Alterungsmodelle und/oder geeigneter mathematischer Modelle zur Umrechnung der Impedanz in den Alterungszustand, ermittelt wird.

Der Batteriestrom der Batterie und die Batteriespannung der Batterie werden jeweils insbesondere über die Zeit aufgetragen. Bei Versuchen im Rahmen der vorliegenden Erfindung hat sich herausgestellt, dass die Betriebsspannung und der Betriebsstrom vorteilhaft zur Ermittlung des Alterungszustandes der Batterie geeignet sind. Erfindungsgemäß werden zur Ermittlung des Alterungszustandes der Batterie demnach ein graphischer Verlauf des Batteriestroms über die Zeit und ein graphischer Verlauf der Batteriespannung beziehungsweise der Einzelspannungen der Batterie über die Zeit ermittelt. Insbesondere werden die graphischen Verläufe dieser Betriebsparameter ermittelt. Zusätzlich, insbesondere zumindest abschnittsweise gleichzeitig, werden vorzugsweise ein Ladezustand der Batterie und/oder eine Temperatur der Batterie ermittelt. Diese Betriebsparameter können anschließend für die Impedanzspektroskopie beziehungsweise die Berechnung der Impedanz der Batterie genutzt werden. In diesem Fall werden anschließend entsprechend der graphische Verlauf hinsichtlich des Batteriestroms auf wenigstens einen sinusförmigen Kurvenabschnitt und der graphische Verlauf hinsichtlich der Batteriespannung auf wenigstens einen sinusförmigen Kurvenabschnitt hin überprüft. Relevante Kurvenabschnitte werden danach extrahiert und jeweils zum Berechnen der Impedanz der Batterie genutzt. Zur Berechnung der Impedanz werden außerdem bevorzugt der zugehörige Ladezustand der Batterie und die zugehörige Temperatur der Batterie, also Ladezustand und Temperatur der Batterie während der Zeit der Erfassung des jeweiligen sinusförmigen Kurvenabschnitts, verwendet.

Weiterhin ist es möglich, dass bei einem Verfahren extrahierte, sinusförmige Kurvenabschnitte gespeichert und in gleiche oder ähnliche Temperaturbereiche der Batterie und/oder gleiche oder ähnliche Ladezustandsbereiche der Batterie klassiert werden, wobei die Impedanzspektroskopie anhand der klassierten sinusförmigen Kurvenabschnitte durchgeführt wird. Bei Versuchen im Rahmen der vorliegenden Erfindung hat sich herausgestellt, dass die Impedanz der Batterie temperatur- und ladezustandsabhängig sein kann. Deshalb ist es von Vorteil, wenn die Impedanzspektroskopie für ähnliche Temperatur- und/oder Ladezustandsbereiche erfolgt. Entsprechend wird bei einem Verfahren eine Klassierung in Temperatur- und/oder Ladezustandsbereiche durchgeführt. Der Alterungszustand der Batterie lässt sich im Rahmen dieser Vorgehensweise mithin besonders genau ermitteln. Ein bevorzugter Temperaturbereich weist beispielsweise ein Temperaturfenster von ca. 10 °C auf. So können sinusförmige Kurvenabschnitte mit Bezug auf Temperaturen der Batterie, die sich maximal um ca. 10 °C voneinander unterscheiden, in vordefinierte Temperaturbereiche klassiert werden. Ein bevorzugter Ladezustandsbereich weist beispielsweise ein Ladezustandsfenster von ca. 10 % auf. So können sinusförmige Kurvenabschnitte mit Bezug auf Ladezustände der Batterie, die sich maximal um ca. 10 % voneinander unterscheiden, in entsprechend definierte Ladezustandsbereiche klassiert werden.

Außerdem ist es möglich, dass bei einem Verfahren das Ermitteln des Verlaufs der Betriebsspannung der Batterie und des Verlaufs des Betriebsstroms der Batterie online durchgeführt wird. Im Rahmen dieser Vorgehensweise kann das Verfahren besonders einfach im mobilen Einsatz, beispielsweise während einer Fahrt des Fahrzeugs, durchgeführt werden.

Darüber hinaus ist es bei einem Verfahren möglich, dass der Verlauf der Betriebsspannung der Batterie und/oder der Verlauf des Betriebsstroms der Batterie zur Verringerung eines Signalrauschens durch einen Signalfilter gefiltert wird. Der gefilterte beziehungsweise geglättete Kurvenverlauf der Betriebsspannung und/oder des Betriebsstroms bietet eine besonders genaue Basis zum Berechnen der Impedanz sowie für die Ermittlung des Alterungszustandes der Batterie. Als Filter kann vorliegend eine Schaltung verwendet werden, mit welcher der Kurvenverlauf abhängig von der Frequenz in der Amplitude und in der Phasenlage derart verändert wird, dass dadurch unerwünschte Signalanteile abgeschwächt oder unterdrückt werden.

Gemäß einer weiteren Ausgestaltungsvariante ist es möglich, dass bei einem Verfahren die sinusförmigen Kurvenabschnitte in einen Cloud-Speicher extrahiert werden und die Impedanzspektroskopie und/oder die Ermittlung des Alterungszustandes im Cloud-Speicher beziehungsweise in der Cloud durchgeführt werden. Außerhalb des Fahrzeugs kann eine Rechenleistung bereitgestellt werden, welche innerhalb des Fahrzeugs nicht oder nur mit unverhältnismäßig hohem Aufwand erreicht werden könnte. Durch eine geringe Anforderung an die Rechenleistung im Fahrzeug können dort auch weniger komplexe Bauteile verbaut werden. Dies kann zu einem geringeren Gewicht im Fahrzeug sowie zu einem reduzierten Kühlbedarf einer Recheneinheit im Fahrzeug führen. Dies ist insbesondere im mobilen Einsatz beziehungsweise bei der mobilen Durchführung des Verfahrens von Vorteil. Neben der Impedanzspektroskopie können auch andere Verfahrensschritte, wie beispielsweise das Speichern und/oder das Extrahieren der sinusförmigen Verläufe, die Klassierung und/oder die Ermittlung des Alterungszustandes der Batterie, anhand der physikalischen Alterungsmodelle und/oder der mathematischen Modelle ausgelagert beziehungsweise in der Cloud durchgeführt werden. Im beschriebenen Fall ist selbstverständlich eine Cloud-Verbindung des Fahrzeugs zum Datenaustausch zu gewährleisten. Ergebnisse in Form eines Alterungszustandes der Batterie könnten dann aus der Cloud beziehungsweise aus dem Cloud-Speicher wieder zurück an das Fahrzeug gesendet werden.

Gemäß einem weiteren Aspekt der vorliegenden Erfindung wird ein Computerprogramm zur Verfügung gestellt, umfassend Befehle, die bei der Ausführung des Computerprogramms durch ein Steuergerät dieses veranlassen, das vorstehend im Detail beschriebene Verfahren auszuführen. Damit bringt das erfindungsgemäße Computerprogramm die gleichen Vorteile mit sich, wie sie ausführlich mit Bezug auf das erfindungsgemäße Verfahren beschrieben worden sind. Das Computerprogramm kann als computerlesbarer Anweisungscode in jeder geeigneten Programmiersprache, wie beispielsweise in JAVA oder C++, implementiert sein. Das Computerprogramm kann auf einem computerlesbaren Speichermedium, wie einer Datendisk, einem Wechsellaufwerk, einem flüchtigen oder nichtflüchtigen Speicher, oder einem eingebauten Speicher/Prozessor, abgespeichert sein. Der Anweisungscode kann einen Computer oder andere programmierbare Geräte, wie das Steuergerät, derart programmieren, dass die gewünschten Funktionen ausgeführt werden. Ferner kann das Computerprogramm in einem Netzwerk, wie beispielsweise dem Internet, bereitgestellt werden beziehungsweise sein, von dem es bei Bedarf von einem Nutzer heruntergeladen werden kann. Das Computerprogramm kann mittels einer Software oder in Form eines Computerprogrammprodukts mittels einer oder mehrerer spezieller elektronischer Schaltungen, das heißt in Hardware, oder in beliebig hybrider Form, das heißt mittels Software-Komponenten und Hardware-Komponenten, realisiert werden beziehungsweise sein.

Darüber hinaus wird im Rahmen der vorliegenden Erfindung ein Speichermittel mit einem darauf gespeicherten Computerprogramm, das zum Durchführen eines wie vorstehend beschriebenen Verfahrens konfiguriert und ausgestaltet ist, zur Verfügung gestellt. Ebenso wird ein Steuergerät mit einem darauf installierten, wie vorstehend beschriebenen Computerprogramm bereitgestellt, das zum Durchführen eines erfindungsgemäßen Verfahrens konfiguriert und ausgestaltet ist. Damit bringen das erfindungsgemäße Speichermittel und das erfindungsgemäße Steuergerät ebenfalls die vorstehend beschriebenen Vorteile mit sich.

Gemäß einem weiteren Aspekt der vorliegenden Erfindung wird ein Fahrzeug mit einem wie vorstehend dargestellten Steuergerät, einem Elektromotor und einer Batterie für eine Energieversorgung des Elektromotors zum Antreiben des Fahrzeugs zur Verfügung gestellt. Damit bringt auch das erfindungsgemäße Fahrzeug die vorstehend beschriebenen Vorteile mit sich. Das Fahrzeug ist vorzugsweise als reines Elektrofahrzeug oder als Hybrid-Elektrofahrzeug ausgestaltet.

Weitere, die Erfindung verbessernde Maßnahmen ergeben sich aus der nachfolgenden Beschreibung zu verschiedenen Ausführungsbeispielen der Erfindung, welche in den Figuren schematisch dargestellt sind. Sämtliche aus den Ansprüchen, der Beschreibung oder den Figuren hervorgehende Merkmale und/oder Vorteile, einschließlich konstruktiver Einzelheiten und räumlicher Anordnungen können sowohl für sich als auch in den verschiedenen Kombinationen erfindungswesentlich sein.

Es zeigen jeweils schematisch:
- Figur 1: ein Ablaufdiagramm zum Erläutern eines Verfahren gemäß einer Ausführungsform der vorliegenden Erfindung,
- Figur 2: ein Blockdiagramm zum Visualisieren des in Figur 1 erläuterten Verfahrens, und
- Figur 3: ein Fahrzeug mit einem Steuergerät und einem darin installierten Computerprogramm gemäß einer Ausführungsform der vorliegenden Erfindung.

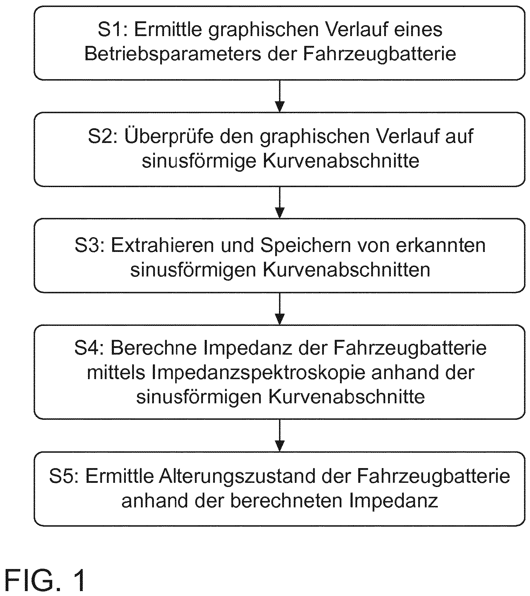

Elemente mit gleicher Funktion und Wirkungsweise sind in den Figuren 1 bis 3 jeweils mit denselben Bezugszeichen versehen.

Figur 1 zeigt ein Flussdiagramm zum Erläutern eines erfindungsgemäßen Verfahrens zur Ermittlung eines Alterungszustandes einer Batterie 10 in Form einer Hochvolt-Fahrzeugbatterie, die zur Energieversorgung eines Elektromotors 20 zum Antreiben eines Fahrzeugs 100 bereitgestellt ist. Gemäß dem Verfahren wird in einem ersten Schritt S1 zunächst der graphische Verlauf des Batteriestroms der Batterie 10 ermittelt. Diese Ermittlung wird online und in Echtzeit durchgeführt. Selbiges wird für die Batteriespannung der Batterie 10 beziehungsweise der einzelnen Batteriezellen der Batterie 10 durchgeführt. Die graphischen Verläufe werden dabei zur Verringerung eines Signalrauschens durch einen Signalfilter gefiltert.

Während der Ermittlung des Batteriestroms und der Batteriespannung beziehungsweise der zugehörigen graphischen Verläufe werden die Temperatur und der Ladezustand (State-of-Charge, SOC) der Batterie für diese Zeitabschnitte erfasst. Das heißt, es wird ermittelt, welche Temperatur und welcher Ladezustand zum Zeitpunkt eines bestimmten Batteriestroms beziehungsweise einer bestimmten Batteriespannung vorliegen.

Anschließend werden die graphischen Verläufe des Stroms und der Spannung der Batterie 10 in einem zweiten Schritt S2 auf sinusförmige Kurvenabschnitte unterschiedlicher Frequenzen hin überprüft beziehungsweise analysiert.

Nachdem sinusförmige Kurvenabschnitte erkannt wurden, werden diese in einem dritten Schritt S3 extrahiert und auf einem Speicher im Fahrzeug 100 gespeichert. In einem vierten Schritt S4 wird nun eine Impedanz der Batterie 10 mittels Impedanzspektroskopie anhand der sinusförmigen Kurvenabschnitte sowie der zugehörigen Temperatur und des zugehörigen Ladezustands berechnet. Hierbei werden die extrahierten, sinusförmigen Kurvenabschnitte gespeichert und in definierte Temperaturbereiche sowie definierte Ladezustandsbereiche der Batterie 10 klassiert, wobei die Impedanzspektroskopie anhand der klassierten sinusförmigen Kurvenabschnitte durchgeführt wird.

In einem anschließenden fünften Schritt S5 wird nun der Alterungszustand der Batterie 10 anhand der berechneten Impedanz ermittelt.

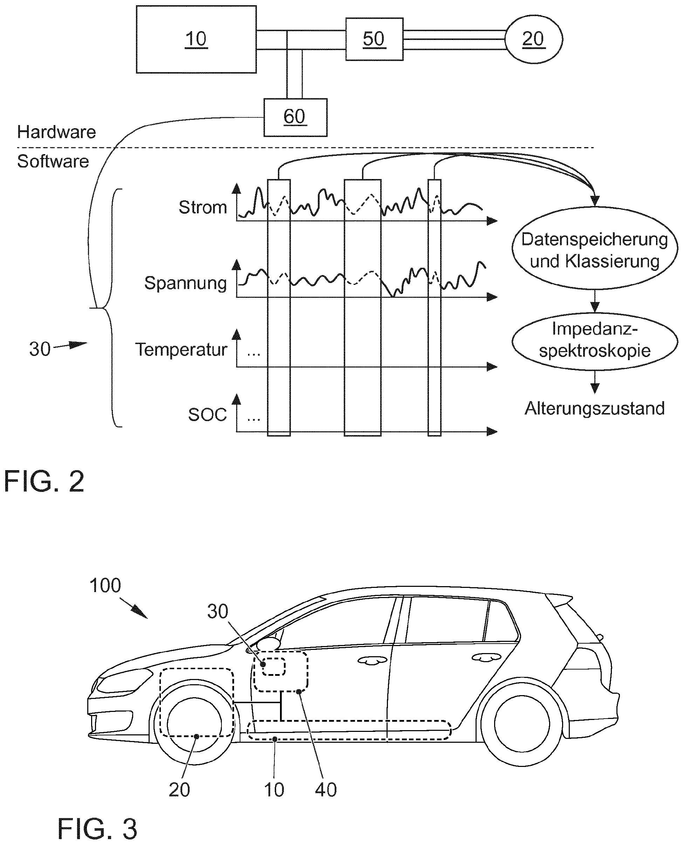

Figur 2 zeigt ein Blockschaltbild zur Visualisierung des vorstehend erläuterten Verfahrens. Wie in Figur 2 dargestellt, steht der Elektromotor 20 mit der Leistungselektronik 50 in Signalverbindung. Die Leistungselektronik 50 steht mit der Batterie 10 sowie einer Sensorik 60 des Fahrzeugs 100 in Signalverbindung. Die Sensorik 60 des Fahrzeugs 100 kann Komponenten wie eine Spannungsmessvorrichtung, eine Strommessvorrichtung, eine Temperaturmessvorrichtung sowie eine Ladezustandsmessvorrichtung umfassen.

In Figur 2 ist ferner ein Computerprogramm 30 visualisiert, welches Befehle umfasst, die bei der Ausführung des Computerprogramms 30 durch einen Computer diesen veranlassen, das vorstehend beschriebene Verfahren auszuführen.

In Figur 3 ist ein Fahrzeug 100 mit einem Steuergerät 40, einem Elektromotor 20 und einer Batterie 10 für eine Energieversorgung des Elektromotors 20 zum Antreiben des Fahrzeugs 100 dargestellt. Auf dem Steuergerät 40 ist ein Computerprogramm 30 installiert, das zum Durchführen des erläuterten Verfahrens konfiguriert und ausgestaltet ist.

Die Erfindung lässt neben den dargestellten Ausführungsformen weitere Gestaltungsgrundsätze zu. Das heißt, die Erfindung soll nicht auf die mit Bezug auf die Figuren erläuterten Ausführungsbeispiele beschränkt betrachtet werden. So ist es beispielsweise möglich, dass die sinusförmigen Kurvenabschnitte in einen Cloud-Speicher extrahiert werden und die Speicherung dieser Daten, die Klassierung, die Impedanzspektroskopie sowie die Ermittlung des Alterungszustandes im Cloud-Speicher durchgeführt werden. Anschließend kann der ermittelte Alterungszustand wieder zurück in das Fahrzeug 100 übermittelt werden.

### Bezugszeichenliste

- 10: Batterie
- 20: Elektromotor
- 30: Computerprogramm
- 40: Steuergerät
- 50: Leistungselektronik
- 60: Sensorik
- 100: Fahrzeug

## Patentansprüche

1. Verfahren zur Ermittlung eines Alterungszustandes einer Batterie (10), die zur Energieversorgung eines Elektromotors (20) eines Fahrzeugs (100) bereitgestellt ist, aufweisend die Schritte:
- Ermitteln eines Verlaufs einer Betriebsspannung der Batterie (10) und eines Betriebsstroms der Batterie (10) in Echtzeit während eines Fahrbetriebs des Fahrzeugs (100),
- Überprüfen des ermittelten Verlaufs der Betriebsspannung der Batterie (10) und des ermittelten Verlaufs des Betriebsstroms der Batterie (10) auf sinusförmige Kurvenabschnitte unterschiedlicher Frequenzen,
- wenn sinusförmige Kurvenabschnitte erkannt werden, Extrahieren der erkannten sinusförmigen Kurvenabschnitte unterschiedlicher Frequenzen,
- Berechnen einer Impedanz der Batterie (10) mittels Impedanzspektroskopie anhand der sinusförmigen Kurvenabschnitte, und
- Ermitteln des Alterungszustandes der Batterie (10) anhand der berechneten Impedanz.

2. Verfahren nach Anspruch 1,
**dadurch gekennzeichnet,**
**dass** extrahierte, sinusförmige Kurvenabschnitte gespeichert und dabei in gleiche oder ähnliche Temperaturbereiche der Batterie (10) und/oder gleiche oder ähnliche Ladezustandsbereiche der Batterie (10) klassiert werden, wobei die Impedanzspektroskopie anhand der klassierten sinusförmigen Kurvenabschnitte durchgeführt wird.

3. Verfahren nach einem der voranstehenden Ansprüche,
**dadurch gekennzeichnet,**
**dass** der Verlauf der Betriebsspannung der Batterie (10) und/oder der Verlauf des Betriebsstroms der Batterie (10) zur Verringerung eines Signalrauschens durch einen Signalfilter gefiltert wird.

4. Verfahren nach einem der voranstehenden Ansprüche,
**dadurch gekennzeichnet,**
**dass** die sinusförmigen Kurvenabschnitte in einen Cloud-Speicher extrahiert werden und die Impedanzspektroskopie und/oder die Ermittlung des Alterungszustandes im Cloud-Speicher durchgeführt werden.

5. Computerprogramm (30), umfassend Befehle, die bei der Ausführung des Computerprogramms (30) durch ein Steuergerät (40) dieses veranlassen, das Verfahren nach einem der Ansprüche 1 bis 4 auszuführen.

6. Speichermittel mit einem darauf gespeicherten Computerprogramm (30), das zum Durchführen eines Verfahrens nach einem der Ansprüche 1 bis 4 konfiguriert und ausgestaltet ist.

7. Steuergerät (40) mit einem darauf installierten Computerprogramm (30) nach Anspruch 5, das zum Durchführen eines Verfahrens nach einem der Ansprüche 1 bis 4 konfiguriert und ausgestaltet ist.

8. Fahrzeug (100) mit einem Steuergerät (40) nach Anspruch 7, einem Elektromotor (20) und einer Batterie (10) für eine Energieversorgung des Elektromotors (20) zum Antreiben des Fahrzeugs (100).

## Claims

1. Method for determining a state of health of a battery (10) which is provided to supply energy to an electric motor (20) of a vehicle (100), having the steps of:
- determining a profile of an operating voltage of the battery (10) and of an operating current of the battery (10) in real time during driving operation of the vehicle (100),
- checking the determined profile of the operating voltage of the battery (10) and the determined profile of the operating current of the battery (10) for sinusoidal curve sections of different frequencies,
- if sinusoidal curve sections are identified, extracting the identified sinusoidal curve sections of different frequencies,
- calculating an impedance of the battery (10) by means of impedance spectroscopy on the basis of the sinusoidal curve sections, and
- determining the state of health of the battery (10) on the basis of the calculated impedance.

2. Method according to Claim 1,
**characterized**
**in that** extracted, sinusoidal curve sections are stored and in the process classified in the same or similar temperature ranges of the battery (10) and/or the same or similar state-of-charge ranges of the battery (10), wherein the impedance spectroscopy is carried out on the basis of the classified sinusoidal curve sections.

3. Method according to either of the preceding claims, **characterized**
**in that** the profile of the operating voltage of the battery (10) and/or the profile of the operating current of the battery (10) are/is filtered through a signal filter in order to reduce signal noise.

4. Method according to one of the preceding claims, **characterized**
**in that** the sinusoidal curve sections are extracted into cloud storage and the impedance spectroscopy and/or the determination of the state of health are/is carried out in the cloud storage.

5. Computer program (30) comprising commands which, when the computer program (30) is executed by a control device (40), cause this to implement the method according to one of Claims 1 to 4.

6. Storage means having a computer program (30) stored thereon, which is configured and designed to carry out a method according to one of Claims 1 to 4.

7. Control device (40) having a computer program (30) according to Claim 5 installed thereon, which is configured and designed to carry out a method according to one of Claims 1 to 4.

8. Vehicle (100) having a control device (40) according to Claim 7, an electric motor (20) and a battery (10) for supplying energy to the electric motor (20) in order to drive the vehicle (100).

## Revendications

1. Procédé permettant de déterminer un état de vieillissement d'une batterie (10) qui est fournie pour l'alimentation en énergie d'un moteur électrique (20) d'un véhicule (100), présentant les étapes consistant à :
- déterminer un tracé d'une tension de fonctionnement de la batterie (10) et d'un courant de fonctionnement de la batterie (10) en temps réel pendant un fonctionnement de conduite du véhicule (100),
- vérifier le tracé établi de la tension de fonctionnement de la batterie (10) et le tracé établi du courant de fonctionnement de la batterie (10) sur des sections de courbe sinusoïdales de différentes fréquences,
- si des sections de courbe sinusoïdales sont identifiées, extraire les sections de courbe sinusoïdales identifiées de différentes fréquences,
- calculer une impédance de la batterie (10) au moyen d'une spectroscopie d'impédance à l'aide des sections de courbe sinusoïdales, et
- déterminer l'état de vieillissement de la batterie (10) à l'aide de l'impédance calculée.

2. Procédé selon la revendication 1,
**caractérisé**
**en ce que** les sections de courbe sinusoïdales extraites sont mémorisées et sont alors classées dans des plages de température identiques ou similaires de la batterie (10) et/ou des plages d'état de charge identiques ou similaires de la batterie (10), dans lequel la spectroscopie d'impédance est effectuée à l'aide des sections de courbe sinusoïdales classées.

3. Procédé selon l'une quelconque des revendications précédentes,
**caractérisé**
**en ce que** le tracé de la tension de fonctionnement de la batterie (10) et/ou le tracé du courant de fonctionnement de la batterie (10) sont filtrés par un filtre de signal pour diminuer un bruit de signal.

4. Procédé selon l'une quelconque des revendications précédentes,
**caractérisé**
**en ce que** les sections de courbe sinusoïdales sont extraites dans une mémoire dématérialisée, et la spectroscopie d'impédance et/ou la détermination de l'état de vieillissement sont effectuées dans la mémoire dématérialisée.

5. Programme informatique (30), comprenant des instructions qui, lors de l'exécution du programme informatique (30) par un appareil de commande (40), font que celui-ci exécute le procédé selon l'une quelconque des revendications 1 à 4.

6. Moyen de stockage avec un programme informatique (30) stocké sur celui-ci qui est configuré et conçu pour exécuter un procédé selon l'une quelconque des revendications 1 à 4.

7. Appareil de commande (40) avec un programme informatique (30) selon la revendication 5 installé sur celui-ci qui est configuré et conçu pour exécuter un procédé selon l'une quelconque des revendications 1 à 4.

8. Véhicule (100) comprenant un appareil de commande (40) selon la revendication 7, un moteur électrique (20) et une batterie (10) pour une alimentation en énergie du moteur électrique (20) pour entraîner le véhicule (100).
